(19) Europäisches Patentamt
European Patent Office
Office européen des brevets

(11) **EP 2 209 136 A1**

(12) **EUROPEAN PATENT APPLICATION**
published in accordance with Art. 153(4) EPC

(43) Date of publication:
**21.07.2010 Bulletin 2010/29**

(51) Int Cl.:
*H01L 21/60* (2006.01)    *C22C 5/02* (2006.01)

(21) Application number: **08846626.3**

(22) Date of filing: **15.10.2008**

(86) International application number:
**PCT/JP2008/068677**

(87) International publication number:
**WO 2009/060698 (14.05.2009 Gazette 2009/20)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **06.11.2007 JP 2007288800**

(71) Applicant: **Tanaka Denshi Kogyo K.K.
Tokyo 100-6422 (JP)**

(72) Inventors:
• **TAKADA, Mitsuo
kanzaki-gun
Saga 842-0031 (JP)**

• **TESHIMA, Satoshi
Kanzaki-gun
Saga 842-0031 (JP)**
• **KUWAHARA, Takeshi
Kanzaki-gun
Saga 842-0031 (JP)**

(74) Representative: **Stona, Daniel et al
Moinas & Savoye S.A.
42, rue Plantamour
1201 Genève (CH)**

(54) **GOLD ALLOY WIRE FOR BALL BONDING**

(57)     [Issues to be solved]
To provide Au alloy wire for ball bonding, which is superior wire strength, and also is superior at formability of molten ball and roundness of compressed ball, moreover is superior at stitch bondability; is available for high density wiring of semiconductor divices.

[Solution means]
Au alloy wire for ball bonding comprising: 15 - 50 wt ppm Mg, 10 - 30 wt ppm Ca, 5 - 20 wt ppm Eu, 5 - 20 wt ppm Y, 5 - 20 wt ppm La and residual Au is more than 99.998 wt % purity, moreover, purity of more than 99.98 wt % Au, mass of additive Ca is less than the value of total amount of additive Eu and additive La, and mass of additive Y is less than the value of total amount of additive Ca and additive Eu, and mass of 20 - 40 wt ppm Mg.

[Fig. 1]

EP 2 209 136 A1

**Description**

FIELD OF THE INVENTION

The present invention relates to Au alloy wire for ball bonding, which is superior at fracture load of tensile test at 4% elongation (described as wire strength hereinafter), and lesser contamination of oxides at surface of molten ball and lesser shrinkage cavities as forming of molten ball, and is superior at stability of ball shape by melting (described as formability of molten ball hereinafter), and is superior at roundness of compressed ball shape when molten ball is bonded (described as roundness of compressed ball shape hereinafter), and is superior at stitch bondability when the wire is bonded wire compressed to frame and/or substrate through capillary (described as stitch bondability hereinafter).

STATE OF THE ART

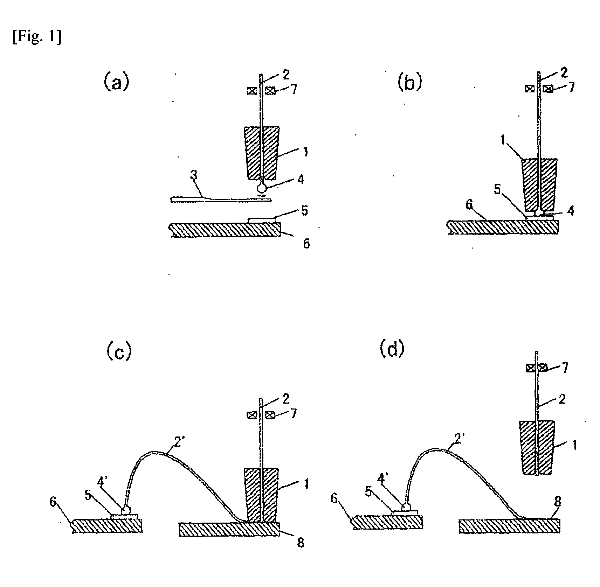

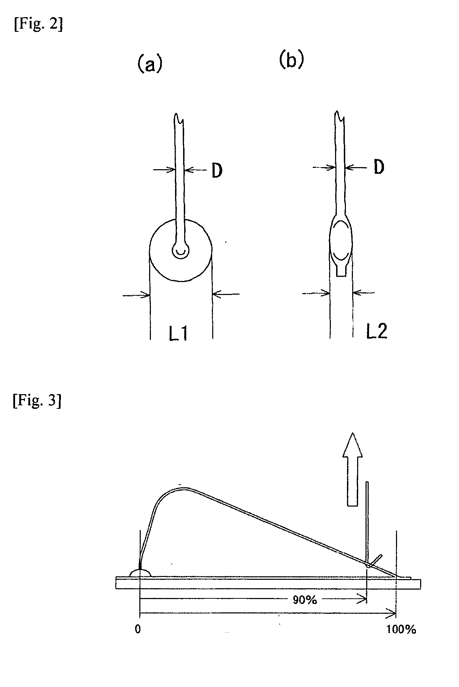

In the case of bonding with electrode of IC chip and outer lead, wire-bonding methods wired through a wire are known. Among these methods as a manner of bonding with Al electrodes of IC chip, thermo-compression and thermo-sonic bonding are occupied mainstream. Where as thermo-sonic bonding, ball-bonding method is used conventionally. Bonding method by ball bonding is explained using the figure illustrated in Reference Patent 1 (Japanese Patent Application No. 3657087) shown hereinafter. As shown in the Fig. 1(a), wire 2 is sent from a thin hole of tip of capillary through wire hole of capillary 1, electric torch 3 is set against the tip, discharging between wire 2, heating and melting the tip of wire 2, ball 4 is formed. Then as shown in the Fig. 1(b), capillary 1 is taken downward, said ball 4 is compressed bonded to Al electrode 5 on the IC chip 6. Where, it is not illustrated here, ultrasonic vibration through capillary 1 is applied and since IC chip 6 is heated at heat block, said ball 4 compressed bonded becomes compressed ball 4'. Then as shown in the Fig. 1(c), capillary 1 is tracing a defined locus, it moves to above the outer circuit wire 8 of lead frame, and it goes down. Then, it is not illustrated here, ultrasonic vibration through capillary 1 is applied, since the outer circuit wire 8 is heated at heat block, side wall of wire 2 is thermal compressed and bonded (kwon as stitch bonding). Then, as shown in the Fig. 1(d), clamper 7 goes upward with keeping clamped wire 2, wire 2 is cut, so wiring is finished.
In general, Au alloy wire for ball bonding should meet to wire strength, formability of molten ball, roundness of compressed ball shape and stitch bondability in practical use. Moreover, elongation rate of conventional ball bonding wire is set at 2 - 6 %, it is preferable more than 3 % of elongation rate considering formability of loop, and especially 4 % is known as most preferable.
On the other hand, in Reference Patent 1, Au alloy wire for wedge bonding had been developed comprising; 1 - 100 wt ppm of additive Ca to high purity Au, which Au purity of said Au alloy wire is more than 99.9 wt %, tensile strength is more than 33.0 kg/mm$^2$, and elongation rate is 1 - 3 %. This Au alloy wire is superior at high temperature tensile strength, and is suitable for high density wiring for IC chip, and had been used by wedge bonding. Portion of bonding by wedge bonding, shown in Fig. 2(b), has a feature of compressed width of wire can be controlled within 1.5 - 2.5 times of wire diameter.
However, when this Au alloy wire is applied to ball bonding, it can't be used for stable ball bonding because of poor roundness of compressed ball shape. Moreover, since elongation rate is lower, it is hard to draw loop shape, and it becomes worse at formability of loop. Hence, the usage is limited as wedge bonding, and range of semiconductor devices as object had been limited.
[Reference Patent 1] JP 3657087
[Reference Patent 2] JPA 1998-4114

DISCLOSURE OF INVENTION

ISSUES TO BE SOLVED BY THE PRESENT INVENTION

The present invention is aim to provide Au alloy wire, in view of the past's above-mentioned circumstances, which is same as conventional Au alloy wire for wedge bonding wire, and is superior at pull strength, and is superior at formability of molten ball and roundness of compressed ball, more over is superior at stitch bondability suitable for high density wiring semiconductor device.

ISSUES TO BE SOLVED BY THE PRESENT INVENTION

The inventors of the present invention had made every effort and investigated on Au alloy wires superior at strength. Consequently if mass of additive Ca is less than value of total amount of Y, Eu and La, and mass of additive Y is less than value of total amount of Eu and La, it has been discovered that Au alloy comprised prescribed trace additive of Ca-Mg-Eu-La-Y has superior effect at wire strength, formability of molten ball, roundness of compressed ball shape, and stitch bondability, and the present invention has been accomplished.

Concretely, according to the present invention, Au alloy wire for ball bonding comprising: 15 - 50 wt ppm Mg, 5 - 20 wt ppm Eu, 5 - 20 wt ppm La, 5 - 20 wt ppm Y, 10 - 30 wt ppm Ca, and residual Au, is provided.

Moreover, according to the present invention, Au alloy wire for ball bonding comprising: 15 - 50 wt ppm Mg, 5 - 20 wt ppm Eu, 5 - 20 wt ppm La, 5 - 20 wt ppm Y, 10 - 30 wt ppm Ca, and residual Au, and mass of additive Ca is less than the value of total amount of additive Eu and additive La, and mass of additive Y is less than the value of total amount of additive Ca and additive Eu, and mass of 20 - 40 wt ppm Mg, is provided.

Moreover, according to the present invention, Au alloy wire for ball bonding comprising: 15 - 50 wt ppm Mg, 5 - 20 wt ppm Eu, 5 - 20 wt ppm La, 5 - 20 wt ppm Y, 10 - 30 wt ppm Ca, with residual Au, and mass of additive Ca is less than the value of total amount of additive Eu and additive La, and mass of additive Y is less than the value of total amount of additive Ca and additive Eu, is provided.

In preferable embodiment, trace additive of 20 - 40 wt ppm Mg is added.

And in preferable embodiment, Au alloy wire for ball bonding is used purity of more than 99.98 wt % Au.

In more preferable embodiment, Au alloy wire for ball bonding is used purity of more than 99.99 wt % Au.

EFFECTS OF THE PRESENT INVENTION

Au alloy wire for ball bonding of the present invention, has superior effect of wire strength, stitch bondability, formability of molten ball and roundness of compressed ball shape as Au alloy comprised prescribed composition of trace additive of Ca-Mg-Eu-La-Y. Especially, it has characteristics of attaining wire strength, stitch bondability, and roundness of compressed ball shape at same time.

DESCRIPTION OF THE MOST PREFERRED EMBODIMENT

In the present invention, variety of additive elements is less and range of component is narrow and definitive. Losing balance of composition ratio of additive elements of the present invention, hence it may have a bad influence upon wire strength, stitch bondability, formability of molten ball and roundness of compressed ball shape, so purity of Au is preferable to be as high as possible. Moreover, in the system of the present invention, it is commercially advantageous, since it is available to display as high purity bonding wire more than 99.99 wt %, if the total amount of trace additive elements except Au and impurity elements is less than 100 wt ppm.

(Stitch bondability and wire strength)

Stitch bonding of bonding wire is classified into solid-phase bonding. Easiness of deformation to form stitched portion and higher strength of bond at stitch portion is known as phenomena, which have significant impact upon solid-phase bonding.

Easiness of deformation to form stitched portion means that deformation by elastic deformation, plastic deformation, creep deformation and diffusion is easy to occur. This phenomenon is same as at stitch bonding, in the case of bonding wire, hence it is considered that the lower strength of wire is the easier deformation for forming stitched portion, so there is a negative correlation between wire strength and stitch bondability.

On the other hand, connected strength at stitched portion is caused by various phenomena such as chemical bond strength, adhesion, surface roughness, surface condition and so on. However, conventional Au alloy wire for ball bonding has originally stronger bonding strength than other metallic bonding wire has. This is because of composition of Au, which purity is 99 wt % - 99.99 wt %, and it does not almost be oxidized in the air. Therefore, it is considered that the lesser ill effect of additive elements and its oxide exist at surface of bonding wire, the stronger strength of stitch bonding portion can be gotten.

When ball bonding Au wire is made using purity of more than 99.999 wt % without any additive element, it may have an advantage of easiness to deformation to form stitch portion because the wire is soft, there is no ill effect of additive elements and its oxide on the surface of wire, so it is considered that it may be the best bonding wire at superior stitch bondability. However, it is required plural functions to bonding wire at the same time, for example, if wire strength is not strong than some level of strength, problems occur in practical use such as poor wire flow at plastic molding and poor loop formability. Consequently, in order to enhance wire strength, it is necessary to use trace additive elements. All trace additive elements of the present invention relate to effect of bonding strength at stitched portion and they are not apt to interfere stitch bondability comparing with pure Au. Moreover, using prescribed composition ratio of trace additive elements of the present invention has also an effect to enhance wire strength. Where, it is considered that existence of oxide of additive elements on the surface of wire is caused to annealing at temperature of about 30 % - 60 % of melting point after final drawing. It may be thought that it could be possible to decrease oxides by annealing in inert gas atmosphere and by chemical cleaning of wire surface after annealing, but there is a problem from the aspect of manufacturing cost, the method of the present invention is more practical.

(Formability of molten ball)

Molten ball means that ball formed by melting tip of bonding wire by spark of discharging in the air. The more volume of the some additive elements, oxide of additive elements is observed at whole surface of ball and at boundary of wire (so called neck). Moreover, in some cases, shrinkage cavities are generated at bottom of ball. On performance of bonding wire, formability of molten ball is important, and it is required that oxide and shrinkage cavities should be lesser as possible. Molten ball formability, which meets to these industrial requirements in practical use is obtained by using prescribed composition ratio of trace additive elements of the present invention.

(Roundness of compressed ball)

Space and area of A1 electrodes on IC chip had become narrower and smaller by higher density implementation of semiconductor devices. When bonding on narrower and smaller Al electrode on space and area, it is necessary and inevitable to improve roundness of compressed ball in order to avoid contact with each other of neighboring compressed ball. Composition ratio of additive elements has great effect to roundness of compressed ball, loosing the balance of composition ratio, deformation of molten ball become heterogeneous at compressed bonding, compressed ball shape can not be kept its roundness. Moreover, roundness of compressed ball has tendency of negative correlation with wire strength as same as stitch bondability. Compatibility of roundness of compressed ball with wire strength for practical use can be attainable using prescribed composition ratio of trace additive elements of the present invention.

[Mg]

Mg in the alloy system of the present invention is the most effective element for roundness of compressed ball. Mg in the alloy system of the present invention as an additive element has not enough effect to wire strength. In the alloy system of the present invention, Mg is necessary to be over than 15 wt ppm, because, less than this, there is no effect to roundness of compressed ball. In the alloy system of the present invention, in order to be stable roundness of compressed ball, Mg is preferable to be over 20 wt ppm. On the other hand, in the alloy system of the present invention, in the case of exceed more than 50 wt ppm Mg, stability of ball shape formed by melting (described as formability of molten ball hereinafter) has mischief. In the alloy system of the present invention, less than 40 wt ppm Mg is preferable in order to keep good formability of molten ball.

[Eu] and [La]

In the alloy system of the present invention, though Eu and La are effective elements to wire strength of bonding wire, they have no effect like Ca described hereinafter. Moreover, in the alloy system of the present invention, though Eu and La are effective elements to roundness of compressed ball shape, they have no effect like Mg. In the alloy system of the present invention, Eu and La are necessary to be over than 5 wt ppm, because, less than this, there is no effect to roundness of compressed ball and wire strength. On the other hand, in the alloy system of the present invention, in the case of exceed more than 20 wt ppm, they have mischief on formability of molten ball.

[Ca]

In the alloy system of the present invention, Ca is the most effective element for wire strength. However, Ca has mischief effect on roundness of compressed ball. Hence, in the alloy system of the present invention, effective composition range of Ca is definitive to such very narrow range like 10 - 30 wt ppm. Only within the range, Ca has such effect in the alloy system of the present invention. Because, in the alloy system of the present invention, less than 10 wt ppm Ca has no effect to wire strength, in the case of over than 30 wt ppm Ca, it has mischief on roundness of compressed ball.

[Y]

In the alloy system of the present invention, Y is an effective trace additive element for wire strength. However, in the alloy system of the present invention, Y as same as Ca is an element which has mischief on roundness of compressed ball. Y is an optional additive element in the alloy system of the present invention, it is necessary to be over than 5 wt ppm Yin order to have the effect of above mentioned. Because of less than this, it is same as the case of no additive of Y. On the other hand, in the alloy system of the present invention, in the case of exceed more than 20 wt ppm Y, it has mischief on roundness of compressed ball.

[Eu+La+Ca]

In the alloy system of the present invention, it is considered that Eu and La have interaction with Ca. Namely, all of Eu, La and Ca is effective additive element, there is synergy to enhance wire strength by co-addition of these trace additive elements.

[Ca] equals to and/or less than ([Eu]+[La])

In the alloy system of the present invention, though Ca is an additive element, which has harmful effect to roundness of compressed ball shape, it is possible to release considerably such mischief of adding Ca to Au by co-addition of Eu and La. It is considered that by co-addition of Eu and La, each element may have such function like shock abosorver matelial, and mischief to roundness of compressed ball by Ca is released comparing with single addition of it.

[Y] equals to and/or less than ([Ca]+[Eu])

Y shows similar effect of addition like Ca, but it is an element, which has harmful effect to roundness of compressed ball diameter than Ca. Especially, in the case of volume of additive Y is more than the value of co-addition volume of Ca and Eu, it appears strong mischief of roundness of compressed ball shape. However, when co-addition of Ca and Eu, each element has shock absorber material effect, there is an effect to be released mischief of roundness of compressed ball shape by Y. Hence, volume of additive Y is necessary to be less than the volume of total additional amount of Ca and Eu.

(1) Wire strength

On wire strength adjusting elongation of 4 %, Au alloy of the present invention had been evaluated using measuring method as same as conventional one. Where, measurement was done at room temperature, at 100 mm gauge length, and at 10 mm / min speed, and was calculated by using following equation from elongation as fracture. Judgement was done by calculating mean value of 5 wires, which conditioned at 4 % elongation of 25 $\mu$ meters diameter wire after final heat treatment, the high value of samples is shown as good. Concretely, it is shown as in "Best" for more than 12.5 g (122.5 mN) of wire strength, as in "Better" for the range of 12.5 g (122.5 mN) - 11.5 g (112.7 mN) of wire strength, as in "Good" for the range of 11.5 g (112.7 mN) - 11.0 g (107.8 mN) of wire strength, and as in "Bad" for range of less than 11.0 g (107.8 mN) of wire strength.
[Equation 1]

$$\text{Elongation} = \frac{\text{Elongated length as fracture (mm)}}{100 \text{ (mm)}} \times 100 \text{ (\%)}$$

(2) Formability of molten ball

Formability of molten ball is possible to confirm easily by conventional scanning microelectoronscopy and optical microscopy.
In the present invention, judgement was done for the samples, which confirmed more than 6 pieces with whole surface contamination of oxide and/or shrinckage cavities by scanning microelectronscopy, shown as in "Bad" and for the samples, which confirmed between 3 - 5 pieces, shown as in "Good", and for the samples, which confiremed less than 2 pieces, shown as in "Best", among 10 wire samples.

(3) Stitch bondability

Stitch bonding means what is deforming the wire by applied load and ultrasonic through capillary, and bonding to Ag, Au, and/or Pd plated frame or substrate. On stitch bondability, Au alloy of the present invention can be kept at high level as same as conventional Au alloy. Measurement method on the present invention is as following; using electroless Au plated FR-4 resin substrate, is shown in the Fig. 3, as setting center of compressed ball as 0 %, and as setting stitch bonding as 100 %, measuring position is at 90 % near at stitch bonding. Samples were measured just after bonding, IC chip side and resin substrate were fit by a jig, the sample wire was pulled upward, then peel strength were measured. Judghment was done by mean value of 30 samples, and higher value of it was evaluated as good. Concretly, it was shown as in "Best" for more than 6.0 g peel strength, shown as in "Better" for 4.5 g - 6.0 g peel strength, shown as in "Good" for 3.0 g - 4.5 g peel strength, and shown as in "Bad" for less than 3.0 g peel strength.

(4) Roundness of compressed ball

Evaluation of roundness of compressed ball was done as following;
Ball bonding was done at condition of compressed ball diameter is 63 $\mu$ meters to Al electrode (thickness of Al: about $7x10^{-8}$ m) on Si chip, then stitch bonding was done between Au plated FR4 resin substrate, and was wired by ball bonding method. 200 samples were wired at the condition of the $3x10^{-3}$ m span. Roundness of compressed ball was evaluated using 50 compressed balls rundam sampled within these wired wires.
Compressed diameters were measured for each direction, such as applied direction of ultrasonic compressed ball, parallel direction of that and horizontal direction of that, lower value of standard deviation from total 50 wired wires was judged as in "Good". Concretly, it was shown as in "Best" for less than 0.8 $\mu$ meters standard deviation, shown as in "Better" for 0.8 $\mu$ meters - 1.2 $\mu$ meters standard deviation, shown as in "Good" for 1.2 $\mu$ meters - 1.5 $\mu$ meters standard deviation, and shown as in "Bad" for more than 1.5 $\mu$ meters standard deviation.

(5) Manufacturing method of Au alloy wire

Preferable manufacturing method of Au alloy wire of the present invention is explained. It is casted into ingot after melting in the vacuum furnace adding prescribed amount of elements into high purity Au. It is applied cold metal forming using ditch roll and drawing mill to the said ingot, and intermediate annealing, after getting thin wire which diameter is 25 $\mu$ meters by final drawing, it is conditioned at 4 % elongation by final annealing.

[Effects]

Au wire, which purity is more than 99.999 wt %, has low wire strength and its wire strength is declined with the passage of time. Hence, Au alloy wire for bonding wire is strengthened than 99.999 wt % purity Au by adding prescribed optional additive elements. Almost all bonding wire in the market are added some rare earth metals such as Be and Ca, these additive elements have effect of strengthening wire strength.
On the other hand, stitch bondability required for bonding wire becomes worse when the more strong wire strength becomes the more hard deformation of contact portion formation described hereinbefore, and in order to strengthen wire strength, bonding strength of contact portion becomes lower by increasing additive elements. In the present invention, strengthening by adding some kinds of additive elements, some additive elements, which have less mischief against bonding strength at bonded portion and do not make stitch bondability worse, are defined, it was found that Ca, Eu, La and Y are the most optimum additive elements, moreover, it was found that adding these elements at once, the wire strength becomes higher.
Where, adding wire strength and stitch bondability, roundness of compressed ball is also required to conventional bonding wire. However, in general, it is known that it is difficult to keep roundness of compressed ball under the condition of higher wire strength, in the alloy system of the present invention, roundness of compressed ball is kept its roundness by using Mg, which has less effect to wire strength.
However, though Au alloy system used even Ca, Eu, La and Ydescribed hereinbefore, which have superior function at wire strength and stitch bondability, it was ascertained that roundness of compressed ball can not be improved in the case of neglected use of interaction of other elements, which improve wire strength, and volume of adding.
Hence, Ca in the alloy system of the present invention was compounded considering volume of adding and interaction with other additive elements, which have effect of enhancing wire strength, paying attention to composition ratio of Ca, Eu and La, consequently it was successful that it was kept effect of improving roundness of compressed ball and it was improved stitch bondability and wire strength at the same time. Concretly, Ca in the alloy system of the present invention is more effective to enhance wire strength of bonding wire than Eu and La. Then as Ca has an effect to wire strength of bonding wire, in order to set effect of Ca subordinated, and in order to set effect of Eu and La primarily, the mass of Ca is defined as less than the sum of Eu and La.

Moreover, Y in the alloy system of the present invention, was composed considering adding volume and interaction with other additive elements, which have function of enhancing wire strength, consequently, paying attention to composition ratio of Ca and Eu, it was successful that stitch bondability and wire strength is improved at once, keeping effect of improvement for roundness of compressed ball. Concretly, Y in the alloy system of the present invention, is more effective for wire strength of bonding wire by adding Ca and Eu at onece. However, if adding Y more than defined volume, it can not be kept roundness of compressed ball, it is defined that the mass of Y should be less than the sum of Ca and Eu.

[Evaluation 1]

Conventional examples, embodiment examples and compartive examples are explained shown in Table 1.

(Conventional examples)

As conventional example 2 is shown Example 38 in Reference Patent 1 (JP 3657087) and as conventional example 3 is shown Example 14 in Reference Patent 2 (JP H10-4114).

(Embodiment examples and compartive examples)

Au alloy ingot of composition in the left column of Table 1 was obtained by casting after melting in the vacuum furnace adding prescribed trace amount of elements into high purity of 99.999 wt % Au. Cold metal forming was applied to the said ingot using ditch roll and drawing mill, and intermediate annealing, after getting thin wire which diameter was 25 μ meters by final drawing, it was conditioned at 4 % elongation by final annealing.

In the embodiment example 1 - 11, volume of addition of additive elements were varied within the range of standard as described in Claim 1, such as 15 - 50 wt ppm Mg, 10 - 30 wt Ca, 5 - 20 wt ppm Eu, 5 - 20 wt ppm Y and 5 - 20 wt ppm La. On the contrary, in compartive example 1 - 10, volume of each additive element was varied slightly out of the range of standard.

(Evaluation method)

Au alloy wire was bonded to Al electrode on IC chip compressing the ball and was stitch bonded to Au plated FR-4 resin substrate using the ball bonding equipment (UTC 1000 Type from Shinkawa Company Ltd.). The condition of IC chip side bonding was as follows: the load was $3.0 \times 1.0 \times 10^{-3}$ N(30 gf), the bonding time was 12 msec, and the ultrasonic output power was 300 mW. On the other hand, bonding condition of FR-4 resin substrate was as follows: the load was $4.3 \times 1.0 \times 10^{-3}$ N(43 gf), the bonding time was 12 msec, and the ultrasonic output power was 400 mW. Bonding temperature, as common bonding condition, considering low temperature bonding, was 140 degree in Celsius, the capillary of SBNS-33CD-AZM-1/16-XL from SPT Company Ltd. was used.

Then using samples right after bonding, roundness of compressed ball was measured from direction of upward of Al electrode, and stitch bondability was measured from wire peeling strength near at FR-4 resin substrate. Measurement results are shown in the right column in Table 1.

[Table 1]

| | | Au | Kinds of additive elements and its ratio (wt ppm) | | | | | Volume of additive (wt ppm) | | | Result of measurement | | | |
|---|---|---|---|---|---|---|---|---|---|---|---|---|---|---|
| | | | Mg | Eu | La | Y | Ca | Total amount | Ca< Eu+La | Y< Eu+Ca | Wire strength | Stitch bondabiliy | Formability of molten ball | Roundness of compressed ball |
| Conventional examples | 1 | Residual | 25 | 10 | *0 | 11 | 25 | 71 | Out of range | OK | Good | Better | Better | Bad |
| | 2 | Residual | 20 | *0 | 20 | *21 | 10 | 71 | OK | Out of range | Good | Better | Better | Bad |
| | 3 | Residual | 29 | 8 | *0 | *0 | 10 | 47 | Out of range | OK | Bad | Better | Better | Bad |
| Embodiment examples | 1 | Residual | *18 | 13 | 13 | 13 | 20 | 77 | OK | OK | Better | Better | Better | Good |
| | 2 | Residual | 30 | 13 | 13 | 13 | 20 | 89 | OK | OK | Better | Better | Better | Better |
| | 3 | Residual | *47 | 13 | 13 | 13 | 20 | 106 | OK | OK | Better | Better | Good | Best |
| | 4 | Residual | 30 | 8 | 13 | 13 | 20 | 84 | OK | OK | Better | Better | Better | Better |
| | 5 | Residual | 30 | 18 | 13 | 13 | 20 | 94 | OK | OK | Better | Better | Better | Better |
| | 6 | Residual | 30 | 13 | 8 | 13 | 20 | 84 | OK | OK | Better | Better | Better | Better |
| | 7 | Residual | 30 | 13 | 18 | 13 | 20 | 94 | OK | OK | Better | Better | Better | Better |
| | 8 | Residual | 30 | 13 | 13 | 8 | 20 | 84 | OK | OK | Better | Better | Better | Best |
| | 9 | Residual | 30 | 13 | 13 | 18 | 20 | 94 | OK | OK | Better | Better | Good | Good |
| | 10 | Residual | 30 | 13 | 13 | 13 | 13 | 82 | OK | OK | Good | Best | Better | Better |
| | 11 | Residual | 30 | 13 | 13 | 13 | 25 | 94 | OK | OK | Better | Good | Good | Good |
| Comparative examples | 1 | Residual | *10 | 13 | 13 | 13 | 20 | 69 | OK | OK | Better | Better | Better | Bad |
| | 2 | Residual | *58 | 13 | 13 | 13 | 20 | 117 | OK | OK | Better | Better | Bad | Better |
| | 3 | Residual | 30 | *2 | 13 | 13 | 20 | 78 | Out of range | OK | Good | Better | Better | Bad |
| | 4 | Residual | 30 | *28 | 13 | 13 | 20 | 104 | OK | OK | Better | Better | Bad | Better |
| | 5 | Residual | 30 | 13 | *2 | 13 | 20 | 78 | Out of range | OK | Good | Better | Better | Bad |
| | 6 | Residual | 30 | 13 | *28 | 13 | 20 | 104 | OK | OK | Better | Better | Bad | Better |
| | 7 | Residual | 30 | 13 | 13 | *2 | 20 | 78 | OK | OK | Bad | Better | Better | Better |
| | 8 | Residual | 30 | 13 | 13 | *28 | 20 | 104 | OK | OK | Best | Bad | Bad | Bad |
| | 9 | Residual | 30 | 13 | 13 | 13 | *5 | 74 | OK | OK | Bad | Best | Better | Better |
| | 10 | Residual | 30 | 13 | 13 | 13 | *38 | 107 | Out of range | OK | Best | Bad | Bad | Bad |

From the results of Table 1 the following matters are recognized.
(1) All conventional examples 1 - 3 were worse at roundness of compressed ball shape, and they do not meet to practical use. The wire strength of conventional example 3 is low, and it does not meet to practical use.
Where, conventional example 1 does not contain La (by indicated * in theTable) and does not meet to [Ca]<[Eu]+[La]. Conventional example 2 does not contain Eu (by indicated * in theTable) and does not meet to [Y] < [Ca] + [Eu] and/or [Y] = [Ca] + [Eu].
Conventional example 3 does not contain La and Y (by indicated * in theTable) and does not meet to [Ca] < [Eu] + [La] and/or [Ca]=[Eu]+[La]. It is cosidered that these are causes of results do not meet to practical use.

(2) All embodiment examples 1 - 11 have good wire strength range, and have aimed characteristics. Moreover, they are all stable at stitch bondability, every sample meets to practical use. All samples have not been obserbed whole surface contamination by oxide and shrinkage cavity scarcely by scanning microelectron scopy, it is obtained that formability of molten ball of all samples meet to practical use. Moreover, every roundness of compressed ball is good and every one meets to practical use. Hence, all embodiment examples 1 - 11 meet to practical use on all evaluation items. Where, all embodiment examples 1 - 11 meet to the range of additive elements, which described in Claim 1, and meet to [Ca]<[Eu]+[La] and/or [Ca]=[Eu]+[La], also [Y]<[Ca]+[Eu] and/or [Y]=[Ca]+[Eu]. It is cosidered that these are causes of satisfactory results meet to practical use.

(3) In compartive example 1 - 10, all samples did not meet to practical use on more than one evaluation items among wire strength, stitch bondability, formability of molten ball and roundness of compressed ball. Where, every comparative example 1 -10 did not meet to the range of additive elements described in Claim 1 (by indicated * in the Table), furthermore, by depending on comparative example, it does not meet also to [Ca]<[Eu]+[La] and/or [Ca]=[Eu]+[La], also [Y]<[Ca]+[Eu] and/or [Y]=[Ca]+[Eu]. Hence, it is cosidered that these are causes of results do not meet to practical use.

Where, concretly, Mg of comparative example 1 does not meet to the lower limit of additive range. Consequently, on the roundness of compressed ball it did not meet to practical use. Mg of comparative example 2 does not meet to the upper limit of additive range. Consequently, on the formability of molten ball it did not meet to practical use. Eu of comparative example 3 does not meet to the lower limit of additive range, and does not meet to also [Ca]<[Eu]+[La] and/or [Ca]=[Eu]+[La]. Consequently, on the roundness of compressed ball it did not meet to practical use. Eu of comparative example 4 does not meet to the upper limit of additive range. Consequetly, on the formability of molten ball it does not meet to practical use. La of comparative example 5 does not meet to the lower limit of additive range, and also does not meet to [Ca]<[Eu]+[La] and/or [Ca]=[Eu]+[La]. Consequently, on the roundness of compressed ball shape it did not meet to practical use. La of comparative example 6 does not meet to the upper limit of additive range. Consequetly, on the formability of molten ball it does not meet to practical use. Y of comparative example 7 does not meet to the lower limit of additive range. Consequetly, on the wire strength it does not meet to practical use. Y of comparative example 8 does not meet to the upper limit of additive range. Consequetly, on the stitch bondability and the formability of molten ball it does not meet to practical use. Ca of comparative example 9 does not meet to the lower limit of additive range. Consequetly, on the wire strength it does not meet to practical use. Ca of comparative example 10 does not meet to the upper limit of additive range and also does not meet to [Ca]<[Eu]+[La] and/or [Ca]=[Eu]+[La]. Consequetly, on the stitch bondability, the formability of molten ball and roundness of compressed ball it does not meet to practical use.

[Evaluation 2]

Embodiment examples and comparative examples shown in Table 2 are explained.

Evaluation 2 was used as same melting method and metal works as in Evaluation 1, and was used Au alloy wires for ball bonding varied composition ratio of additive elements. Where, on evaluation method of Evaluation 2 is same as Evaluation 1.

In the Evaluation 2 effects of amount of optional 2 additive elements varied from among 5 elements of Mg. Ca, Eu, Y and La were evaluated (Total 20 combinations). Volume of one of 2 elements is varied at out of the lower limit of standard, near at the lower limit within standard, near at the upper limit within standard and out of the upper limit of standard. On the contrary, volume of another element is varied at out of the upper limit of standard, near at the upper limit within standard, near at the lower limit of standard, and out of the lower limit of standard. Moreover, it is defined as embodiment examples, which meet to standard and as comparative examples, which do not meet to standard.

For instance, in embodiment example 1 - 2 and comparative example 1 - 2, a combination of 2 elements of Mg and Eu was selected. The range of additive elements is defined as standard described in Claim 1 as 15 - 50 wt ppm Mg, 5 - 20 wt ppm Eu.

Concretly, Mg was varied in oreder of 10 wt ppm, 18 wt ppm, 42 wt ppm, 58 wt ppm, Eu was varied in order of 28 wt ppm, 18 wt ppm, 8 wt ppm, 2 wt ppm. In Evaluation 2, 2 elements were varied within standard and out of standard, bondability was evaluated as same as Evaluation 1.

As same manner, in embodiment example 3 - 4 and comparative example 3 - 5, Mg and La were selected, in embodiment example 5 - 6 and comparative example 5 - 6, Mg and Y were selected, in embodiment example 7 - 8 and comparative example 7 - 8, Mg and Ca were selected, in embodiment example 9 - 10 and comparative example 9 - 10, Eu and La were selected, in embodiment example 11 - 12 and comparative example 11 - 12, Eu and Y were selected, in embodiment example 13 - 14 and comparative example 13 - 14, Eu and Ca were selected, in embodiment example 15 - 16 and comparative example 15 - 16, La and Y were selected, in embodiment example 17 - 18 and comparative example 17 - 18, La and Ca were selected, in embodiment example 19 - 20 and comparative example 19 - 20, Y and Ca were selected.

Where, each additive elements are defined as standard described in Claim 1 as 15 - 50 wt ppm Mg, 10 - 30 wt ppm Ca, 5 - 20 wt ppm Eu, 5 - 20 wt ppm Y, and 5 - 20 wt ppm La.

[Table 2]

| | | | Kinds of additive elements and its ratio (wt ppm) | | | | | | Calculated results (wt ppm) | | | Measurment results | | | |
|---|---|---|---|---|---|---|---|---|---|---|---|---|---|---|---|
| | | Au | Mg | Eu | La | Y | Ca | Total amount | Ca<Eu+La | Y<Eu+Ca | Wire strength | Stitch bondabiliy | Formability of molten ball | Roundness of compressed ball |
| Embodiment examples | 1 | Residual | 18 | 18 | 15 | 13 | 18 | 82 | OK | OK | Better | Better | Good | Good |
| | 2 | Residual | 42 | 8 | 15 | 13 | 18 | 96 | OK | OK | Good | Better | Good | Better |
| | 3 | Residual | 18 | 15 | 18 | 13 | 18 | 82 | OK | OK | Better | Better | Good | Good |
| | 4 | Residual | 42 | 15 | 8 | 13 | 18 | 96 | OK | OK | Good | Better | Good | Better |
| | 5 | Residual | 18 | 15 | 15 | 18 | 18 | 84 | OK | OK | Better | Better | Better | Better |
| | 6 | Residual | 42 | 15 | 15 | 8 | 18 | 98 | OK | OK | Good | Better | Good | Better |
| | 7 | Residual | 18 | 15 | 15 | 13 | 22 | 83 | OK | OK | Better | Better | Better | Better |
| | 8 | Residual | 42 | 15 | 15 | 13 | 13 | 98 | OK | OK | Good | Better | Good | Better |
| | 9 | Residual | 30 | 18 | 8 | 13 | 18 | 87 | OK | OK | Better | Better | Good | Better |
| | 10 | Residual | 30 | 8 | 18 | 13 | 18 | 87 | OK | OK | Better | Better | Good | Better |
| | 11 | Residual | 30 | 18 | 15 | 8 | 18 | 89 | OK | OK | Good | Better | Good | Better |
| | 12 | Residual | 30 | 8 | 15 | 18 | 18 | 89 | OK | OK | Better | Better | Good | Good |
| | 13 | Residual | 30 | 18 | 15 | 13 | 13 | 89 | OK | OK | Good | Better | Good | Better |
| | 14 | Residual | 30 | 8 | 15 | 13 | 22 | 88 | OK | OK | Better | Good | Better | Better |
| | 15 | Residual | 30 | 15 | 18 | 8 | 18 | 89 | OK | OK | Good | Better | Better | Better |
| | 16 | Residual | 30 | 15 | 8 | 18 | 18 | 89 | OK | OK | Better | Better | Better | Good |
| | 17 | Residual | 30 | 15 | 18 | 13 | 13 | 89 | OK | OK | Good | Better | Good | Better |
| | 18 | Residual | 30 | 15 | 8 | 13 | 22 | 88 | OK | OK | Better | Better | Better | Good |
| | 19 | Residual | 30 | 15 | 15 | 8 | 28 | 96 | OK | OK | Good | Better | Better | Good |
| | 20 | Residual | 30 | 15 | 15 | 18 | 13 | 91 | OK | OK | Good | Better | Better | Good |
| Comparative examples | 1 | Residual | *10 | *28 | 15 | 13 | 18 | 84 | OK | OK | Better | Better | Good | Bad |
| | 2 | Residual | *58 | *2 | 15 | 13 | 18 | 106 | Out of range | OK | Good | Better | Bad | Good |
| | 3 | Residual | *10 | 15 | *28 | 13 | 18 | 84 | OK | OK | Better | Better | Good | Bad |
| | 4 | Residual | *58 | 15 | *2 | 13 | 18 | 106 | Out of range | OK | Good | Better | Bad | Good |
| | 5 | Residual | *10 | 15 | 15 | *28 | 18 | 86 | OK | OK | Better | Better | Good | Bad |
| | 6 | Residual | *58 | 15 | 15 | *2 | 18 | 108 | OK | OK | Bad | Best | Bad | Good |
| | 7 | Residual | *10 | 15 | 15 | 13 | *38 | 91 | Out of range | OK | Best | Bad | Good | Bad |
| | 8 | Residual | *58 | 15 | 15 | 13 | *5 | 106 | OK | OK | Bad | Best | Bad | Good |
| | 9 | Residual | 30 | *28 | *2 | 13 | 18 | 91 | OK | OK | Good | Better | Good | Bad |
| | 10 | Residual | 30 | *2 | *28 | 13 | 18 | 91 | OK | OK | Good | Better | Good | Bad |
| | 11 | Residual | 30 | *28 | 15 | *2 | 18 | 93 | OK | OK | Bad | Better | Good | Better |
| | 12 | Residual | 30 | *2 | 15 | *28 | 18 | 93 | Out of range | Out of range | Good | Better | Good | Bad |
| | 13 | Residual | 30 | *28 | 15 | 13 | *5 | 91 | OK | OK | Bad | Better | Good | Better |
| | 14 | Residual | 30 | *2 | 15 | 13 | *38 | 98 | Out of range | OK | Better | Good | Bad | Bad |
| | 15 | Residual | 30 | 15 | *28 | *2 | 18 | 93 | OK | OK | Bad | Better | Good | Better |
| | 16 | Residual | 30 | 15 | *2 | *28 | 18 | 93 | Out of range | OK | Good | Better | Good | Bad |
| | 17 | Residual | 30 | 15 | *28 | 13 | *5 | 91 | OK | OK | Bad | Better | Good | Better |
| | 18 | Residual | 30 | 15 | *2 | 13 | *38 | 98 | Out of range | OK | Better | Good | Bad | Bad |
| | 19 | Residual | 30 | 15 | 15 | *2 | *38 | 100 | Out of range | OK | Good | Better | Bad | Bad |
| | 20 | Residual | 30 | 15 | 15 | *28 | *5 | 93 | OK | Out of range | Bad | Best | Good | Bad |

From the results in Table 2 the followings are recognized. (1) Embodiment examples 1 - 20 are all in the good range at wire strength and are obtained aimed characteristics. Moreover, all are stable at stitch bondability, satisfactory results are obtained to meet to practical use. All examples have not whole contamination of oxides and shrinkage cavities from observation by scanning microelectronscopy, satisfactory results are obtained to meet to practical use on formability of molten ball for every example. Moreover, all examples are good at roundness of compressed ball, satisfactory results are obtained to meet to practical use. Hence, it shows that for embodiment examples 1 - 20 satisfactory results are obtained to meet to practical use at all evaluation items. Where, all embodiment examples 1 - 20 meet to the additive range described in Claim 1 and also meet to equations of [Ca]<[Eu]+[La] and/or [Ca]=[Eu]+[La], also [Y]<[Ca]+[Eu] and/or [Y]=[Ca]+[Eu]. Hence, it is cosidered that these are causes of results do meet to practical use.

(3) Comparative examples 1 - 20 do not meet to practical use on more than one evaluation item among wire strength, stitch bondability, formability of molten ball and roundness of compressed ball. Every comparative example does not meet to the range of additive elements described in Claim 1 at 2 elements (by indicated * in theTable) and also does not meet to [Ca]<[Eu]+[La] and/or [Ca]=[Eu]+[La], also [Y]<[Ca]+[Eu] and/or [Y]=[Ca]+[Eu]. Hence, it is cosidered that these are causes of results do not meet to practical use.

Concretly, on comparative example 1, volume of additive Mg does not meet to the lower limit and volume of additive Eu does not meet to the upper limit. Consequetly, on the roundness of compressed ball result does not meet to practical use. On comparative example 2, volume of additive Mg does not meet to the upper limit and volume of additive Eu does not meet to the lower limit. Moreover it does not meet to [Ca]<[Eu]+[La] and/or [Ca]=[Eu]+[La]. Consequetly, on the formability of molten ball, result does not meet to practical use. On comparative example 3, volume of additive Mg does not meet to the lower limit and volume of additive La does not meet to the upper limit. Consequetly, on the roundness of compressed ball result does not meet to practical use. On comparative example 4, volume of additive Mg does not meet to the upper limit and volume of additive La does not meet to the lower limit. Moreover it does not meet to [Ca]<[Eu]+[La] and/or [Ca]=[Eu]+[La]. Consequetly, on the formability of molten ball, result does not meet to practical use. On comparative example 5, volume of additive Mg does not meet to the lower limit and volume of additive Y does not meet to the upper limit. Consequetly, on the roundness of compressed ball result does not meet to practical use. On comparative example 6, volume of additive Mg does not meet to the upper limit and volume of additive Y does not meet to the lower limit. Consequetly, on wire strength and formability of molten ball result does not meet to practical use. On comparative example 7, volume of additive Mg does not meet to the lower limit and volume of additive Ca does not meet to the upper limit. Moreover it does not meet to [Ca]<[Eu]+[La] and/or [Ca]=[Eu]+[La]. Consequetly, on the stitch bondability and roundness of compressed ball, result does not meet to practical use. On comparative example 8, volume of additive Mg does not meet to the upper limit and volume of additive Ca does not meet to the lower limit. Consequetly, on the wire strength and roundness of compressed ball and formability of molten ball, result does not meet to practical use. On comparative example 9, volume of additive Eu does not meet to the upper limit and volume of additive La does not meet to the lower limit. Consequetly, on the roundness of compressed ball, result does not meet to practical use. On comparative example 10, volume of additive Eu does not meet to the lower limit and volume of additive La does not meet to the upper limit. Consequetly, on the roundness of compressed ball, result does not meet to practical use. On comparative example 11, volume of additive Eu does not meet to the upper limit and volume of additive Y does not meet to the lower limit. Consequetly, on the wire strength, result does not meet to practical use. On comparative example 12, volume of additive Eu does not meet to the lower limit and volume of additive Y does not meet to the upper limit. Moreover it does not meet to [Ca]<[Eu]+[La] and/or [Ca]=[Eu]+[La] and also it does not meet to [Y]<[Ca]+[Eu] and/or [Y]=[Ca]+[Eu]. Consequetly, on the roundness of compressed ball, result does not meet to practical use. On comparative example 13, volume of additive Eu does not meet to the upper limit and volume of additive Ca does not meet to the lower limit. Consequetly, on the wire strength, result does not meet to practical use. On comparative example 14, volume of additive Eu does not meet to the lower limit and volume of additive Ca does not meet to the upper limit. Moreover it does not meet to [Ca]<[Eu]+[La] and/or [Ca]=[Eu]+[La]. Consequetly, on the formability of molten ball and roundness of compressed ball, result does not meet to practical use. On comparative example 15, volume of additive La does not meet to the upper limit and volume of additive Y does not meet to the lower limit. Consequetly, on the wire strength, result does not meet to practical use. On comparative example 16, volume of additive La does not meet to the lower limit and volume of additive Y does not meet to the upper limit. Moreover it does not meet to [Ca]<[Eu]+[La] and/or [Ca]=[Eu]+[La]. Consequetly, on the roundness of compressed ball, result does not meet to practical use. On comparative example 17, volume of additive La does not meet to the upper limit and volume of additive Ca does not meet to the lower limit. Consequetly, on the wire strength, result does not meet to practical use. On comparative example 18, volume of additive La does not meet to the lower limit and volume of additive Ca does not meet to the upper limit. Moreover it does not meet to [Ca]<[Eu]+[La] and/or [Ca]=[Eu]+[La]. Consequetly, on the formability of molten ball and roundness of compressed ball, result does not meet to practical use. On comparative example 19, volume of additive Y does not meet to the lower limit and volume of additive Ca does not meet to the upper limit. Moreover it does not meet to [Ca]<[Eu]+[La] and/or [Ca]=[Eu]+[La]. Consequetly, on the formability of molten ball and roundness of compressed ball, result does not meet to practical use. On comparative example 20, volume of additive Y does not meet to the upper limit and volume of additive Ca does not meet to the lower limit. Moreover it does not meet to [Y]<[Ca]+[Eu] and/or [Y]=[Ca]+[Eu]. Consequetly, on the wire strength and roundness of compressed ball, result does not meet to practical use.

[POSSIBILITY FOR INDUSTRIAL USE]

According to Au alloy wire for ball bonding of the present invention, Au alloy comprising prescribed range of trace additive Ca-Mg-Eu-La-Y has superior effect at wire strength, stitch bondability, roundness of compressed ball and formability of molten ball, and is effective for improving manufacturability of semiconductor equipment. Especially, attaining wire strength, stitch bondability and roundness of compressed ball at once, it is effective for improving manufacturability of semiconductor device, such as BGA low temperature package used electroless Au plating, which is known that ball bonding is difficult with narrow pitch and high density and stitch bonding is also difficult.

BRIEF DESCRIPTION OF THE DRAWINGS

[Fig. 1] Explanatory schema of bonding method by ball bonding
[Fig. 2] (a) and (b) are shown shape and size of bonding portion by ball bonding method and stitch bonding method
[Fig. 3] Explanatory schema of measuring methof of bonding strength of bonding wire

[Explanation of symbols]

| | |
|---|---|
| 1 | Capillary |
| 2 | Wire |
| 3 | Electrode torch |
| 4 | Ball |
| 4' | Compressed ball |
| 5 | Al electrode |
| 6 | IC Chip |
| 7 | Clamper |
| 8 | Outer wiring |
| D | Wire diameter |
| L1 | Compressed ball diameter |
| L2 | Compressed width |

**Claims**

1. Au alloy wire for ball bonding comprising: 15 - 50 wt ppm Mg, 10 - 30 wt ppm Ca, 5 - 20 wt ppm Eu, 5 - 20 wt ppm Y, 5 - 20 wt ppm La and residual Au is more than 99.99 wt % purity, which is used purity of more than 99.998 wt % Au.

2. Au alloy wire for ball bonding comprising: 15 - 50 wt ppm Mg, 10 - 30 wt ppm Ca, 5 - 20 wt ppm Eu, 5 - 20 wt ppm Y, 5 - 20 wt ppm La and residual Au is more than 99.98 wt % purity, which is used purity of more than 99.998 wt % Au.

3. Au alloy wire for ball bonding according to claim 1, where in the component of the wire is comprising: mass of additive Ca is less than the value of total amount of additive Eu and additive La, and mass of additive Y is less than the value of total amount of additive Ca and additive Eu, and mass of 20 - 40 wt ppm Mg.

4. Au alloy wire for ball bonding according to claim 1, where in the component of the wire is comprising: mass of additive Ca is less than the value of total amount of additive Eu and additive La, and mass of 20 - 40 wt ppm Mg.

5. Au alloy wire for ball bonding according to claim 1, where in the component of the wire is comprising: mass of additive Ca is less than the value of total amount of additive Eu and additive La, and mass of additive Y is less than the value of total amount of additive Ca and additive Eu.

6. Au alloy wire for ball bonding according to claim 1, where in the component of the wire is comprising: mass of additive Ca is less than the value of total amount of additive Eu and additive La.

7. Au alloy wire for ball bonding according to claim 2, where in the component of the wire is comprising: mass of additive Ca is less than the value of total amount of additive Eu and additive La, and mass of additive Y is less than the value of total amount of additive Ca and additive Eu, and mass of 20 - 40 wt ppm Mg.

8. Au alloy wire for ball bonding according to claim 2, where in the component of the wire is comprising: mass of additive Ca is less than the value of total amount of additive Eu and additive La, and mass of 20 - 40 wt ppm Mg.

9. Au alloy wire for ball bonding according to claim 2, where in the component of the wire is comprising: mass of additive Ca is less than the value of total amount of additive Eu and additive La, and mass of additive Y is less than the value of total amount of additive Ca and additive Eu.

10. Au alloy wire for ball bonding according to claim 2, where in the component of the wire is comprising: mass of additive Ca is less than the value of total amount of additive Eu and additive La.

11. Au alloy wire for ball bonding comprising: 15 - 50 wt ppm Mg, 10 - 30 wt ppm Ca, 5 - 20 wt ppm Eu, 5 - 20 wt ppm Y, 5 - 20 wt ppm La and residual Au is more than 99.99 wt % purity, which is used purity of more than 99.995 wt % Au.

12. Au alloy wire for ball bonding comprising: 15 - 50 wt ppm Mg, 10 - 30 wt ppm Ca, 5 - 20 wt ppm Eu, 5 - 20 wt ppm Y, 5 - 20 wt ppm La and residual Au is more than 99.98 wt % purity, which is used purity of more than 99.995 wt % Au.

[Fig. 1]

(a)

(b)

(c)

(d)

[Fig. 2]

(a)          (b)

[Fig. 3]

| INTERNATIONAL SEARCH REPORT | International application No. |
|---|---|
| | PCT/JP2008/068677 |

**A. CLASSIFICATION OF SUBJECT MATTER**
*H01L21/60(2006.01)i, C22C5/02(2006.01)i*

According to International Patent Classification (IPC) or to both national classification and IPC

**B. FIELDS SEARCHED**

Minimum documentation searched (classification system followed by classification symbols)
H01L21/60, C22C5/02

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 9-36162 A  (Tanaka Denshi Kogyo Kabushiki Kaisha), 07 February, 1997 (07.02.97), Par. Nos. [0035] to [0036] & US 5702814 A        & EP 743679 A2 & KR 10-0232115 B | 1-12 |
| A | JP 2001-345342 A  (Tanaka Denshi Kogyo Kabushiki Kaisha), 14 December, 2001 (14.12.01), Column 3, line 11 to column 4, line 13; Par. No. [0047] & US 2002/0007957 A1    & EP 1160344 A1 & CN 1326224 A | 1-12 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 November, 2008 (04.11.08) | 11 November, 2008 (11.11.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/068677

C (Continuation).   DOCUMENTS CONSIDERED TO BE RELEVANT

| Category* | Citation of document, with indication, where appropriate, of the relevant passages | Relevant to claim No. |
|---|---|---|
| A | JP 10-98062 A   (Tanaka Denshi Kogyo Kabushiki Kaisha),<br>14 April, 1998 (14.04.98),<br>Claims<br>& US 5945065 A          & EP 822264 A1<br>& CN 1172349 A | 1-12 |
| A | JP 10-98063 A   (Tanaka Denshi Kogyo Kabushiki Kaisha),<br>14 April, 1998 (14.04.98),<br>Claims<br>& US 5945065 A          & EP 822264 A1<br>& CN 1172349 A | 1-12 |
| A | JP 2003-133362 A  (Nippon Steel Corp.),<br>09 May, 2003 (09.05.03),<br>Claims<br>(Family: none) | 1-12 |
| A | WO 2006/057230 A1  (Tanaka Denshi Kogyo Kabushiki Kaisha),<br>01 June, 2006 (01.06.06),<br>Claims<br>& US 2007/0298276 A     & EP 1830398 A1<br>& KR 10-2007-0084296 A  & CN 101065838 A | 1-12 |
| A | JP 2004-22887 A  (Tanaka Denshi Kogyo Kabushiki Kaisha),<br>22 January, 2004 (22.01.04),<br>Claims<br>(Family: none) | 1-12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3657087 B
- JP 10004114 A
- JP H104114 B